(19) Europäisches Patentamt
European Patent Office
Office européen des brevets

(11) **EP 1 783 644 A1**

(12) **EUROPEAN PATENT APPLICATION**

(43) Date of publication:
**09.05.2007 Bulletin 2007/19**

(51) Int Cl.:
***G06F 17/50*** *(2006.01)*

(21) Application number: **06250343.8**

(22) Date of filing: **23.01.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **26.10.2005 JP 2005310683**

(71) Applicant: **FUJITSU LIMITED**
**Kawasaki-shi,**
**Kanagawa 211-8588 (JP)**

(72) Inventor: **Tsubamoto, Daita,**
**Kawasaki-shi,**
**Kanagawa 211-8588 (JP)**

(74) Representative: **Stebbing, Timothy Charles**
**Haseltine Lake**
**Lincoln House**
**300 High Holborn**
**London WC1V 7JH (GB)**

(54) **Digital circuit design comprising sending an executable file from a server to a client**

(57) A circuit design support apparatus that supports design of a digital circuit, comprising: a storage section (12) that stores a standard design-flow file that represents the design procedure of a digital circuit and an examination tool file to be specified, as a program serving as an element of the design procedure, by the standard design-flow file; and a communication section (11) that transmits the standard design-flow file to a client (2) according a request from the client and transmits the examination tool file to the client (2) according to a request from the client.

FIG.1

**Description**

The present invention relates to a circuit design support apparatus, a circuit design support program, and circuit design support method that support design of a circuit carrying digital signals (below, "digital transmission circuit").

In recent years, information throughput requirements demanded in digital electronic equipment grow steadily. Accordingly, a large number of digital signals are present in the equipment. In designing circuits for use in such digital electronic equipment, high signal integrity, free from code error, must be guaranteed for such a large number of signal wirings. Therefore, quality assurance has been achieved by previously establishing a design rule and distributing the rule to a designer to oblige him or her to comply with it.

However, the amount of information contained in the design rule is enormous and therefore it is very difficult to check whether the designer grasps all design rules. In addition, it is very difficult for the designer to determine whether design of all wirings conforms to the design rule. Further, it is necessary to secure adequate human resources in order to conduct a comprehensive verification of a digital circuit system.

The present invention has been made in view of the above problems and embodiments thereof may provide a circuit design support apparatus, a circuit design support program, and a circuit design support method for efficiently designing a digital circuit making good use of available (human) design resources.

According to a first aspect of the present invention, there is provided a digital transmission circuit design support apparatus that supports design of a digital transmission circuit, comprising: an acquisition section that acquires a standard design-flow file that represents the design procedure of a digital transmission circuit and an examination tool file to be specified, as a program serving as an element of the design procedure, by the standard design-flow file; and a communication section that transmits the standard design-flow file to a client (e.g., client computer) according to a request from the client and transmits the examination tool file to the client according to a request from the client.

Preferably, the examination tool file is received and executed by the client, acquires information input to the client by a user (i.e. a human designer), performs processing for the acquired input information, and allows the client to display a processing result.

Alternatively, the examination tool file is received and executed by the client, acquires information input to the client, and allows the input information to be transmitted from the client to the digital transmission circuit design support apparatus, in which case, preferably, the apparatus further comprises an input information processing section that performs processing for the input information based on the input information received from the client.

Various types of input information can be input by the user. The input information may be a design condition of the digital transmission circuit, in which case the processing for the input information is determination whether the input information is a valid value or not.

Meanwhile, the processing for the input information may be calculation of an implementation instruction such as a wiring length, which is performed based on the input information.

Alternatively, the input information may be an answer corresponding to a previously prepared question, the answer being input by the user, and the processing for the input information may be determination of a designer's skill level of the user, which is made based on the answer.

The processing for the input information may also determine a design method suited to the designer's skill or determine a design schedule suited to the designer's skill.

Another possible type of input information is a type of printed circuit boards and wiring length that have been previously classified in terms of a loss, and then the processing for the input information is determination of a frequency characteristic, which is made based on the type of the printed circuit boards and wiring length and creation of a transmission path simulation model, which is performed based on the frequency characteristic.

According to a second aspect of the present invention, there is provided a digital transmission circuit design support program to be transmitted from a server to a client and allowing a computer to execute a digital transmission circuit design support method, the program allowing the computer to execute: a standard design-flow file display step that displays a standard design-flow file that represents the design procedure of a digital transmission circuit; and an examination tool file execution step that executes an examination tool file to be specified, as a program serving as an element of the design procedure, by the standard design-flow file.

The digital transmission circuit design support program according to the present invention has the same optional or preferable features as set out above with regard to the apparatus.

According to a third aspect of the present invention, there is provided a digital transmission circuit design support method that supports design of a digital transmission circuit, comprising: a standard design-flow file display step that displays a standard design-flow file that represents the design procedure of a digital transmission circuit; and an examination tool file execution step that executes an examination tool file to be specified, as a program serving as an element of the design procedure, by the standard design-flow file.

In the embodiments of the present invention, design rules are stored in a server in the form of files, and a desired file is transmitted to a client and executed. With this configuration, even a designer who is not familiar with digital circuit design can easily design the circuit on the client side.

Reference will now be made, by way of example only, to the accompanying drawings in which:

FIG. 1 is a block diagram showing an example of a digital transmission circuit design support system according to the present invention;

FIG. 2 is a sequence diagram showing an example of operation of the digital transmission circuit design support system according to the present invention;

FIG. 3 is a view showing an example of an execution result of a design condition determination tool file according to the present invention;

FIG. 4 is a view showing an example of an execution result of an educational tool file according to the present invention;

FIG. 5 is a view showing an example of an execution result of the design condition determination tool file according to the present invention that deals with a plurality of interface groups; and

FIG. 6 is a view showing an example of a loss class according to the present invention.

In the following description, references to a "digital transmission circuit" include any circuit which inputs and/or outputs digital signals.

An embodiment of the present invention will be described below with reference to the accompanying drawings.

Firstly, the configuration of a digital transmission circuit design support system including a digital transmission circuit design support according to the present invention will be described.

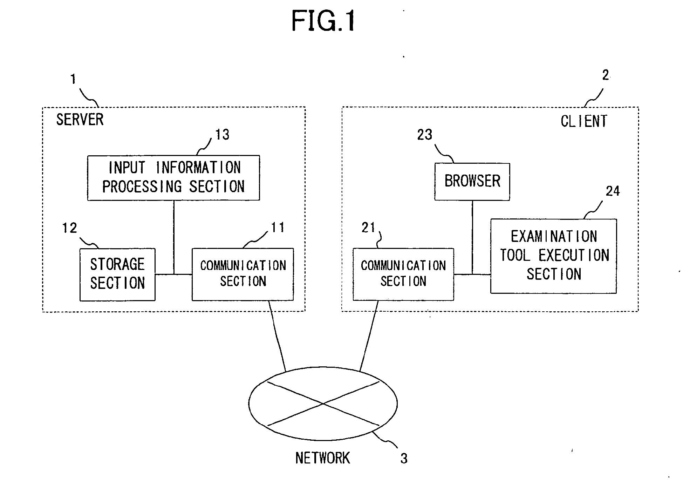

FIG. 1 is a block diagram showing an example of a digital transmission circuit design support system according to the present invention. The digital transmission circuit design support system is constituted by a server 1 serving as a digital transmission circuit design support apparatus, a client 2 that a user who is a digital transmission circuit designer operates, and a network 3. The server 1 and client 2 are connected to each other through the network 3. The server 1 includes a communication section 11, a storage section 12, and an input information processing section 13. The client 2 includes a communication section 21, a browser 23, and an examination tool execution section 24. The communication section 11 and communication section 21 are connected to the network 3, respectively.

A standard design-flow file and examination tool file are previously stored in the storage section 12. The standard design-flow file is a file that represents the design procedure of a digital transmission circuit and can be viewed on the browser 23. The examination tool file is represented as an element of the standard design-flow file and is executed by the examination tool execution section 24 according to a user's instruction made on the standard design-flow file. When being executed by the examination tool execution section 24, the examination tool file displays previously set display information, acquires input information corresponding to user's input operation, and calculates or transmits the input information. A calculation method is previously set based on a design rule. In the embodiment of the present invention, the examination tool execution section 24 is a spreadsheet application and is called by the browser 23. The examination tool file has a file type corresponding to the spreadsheet application.

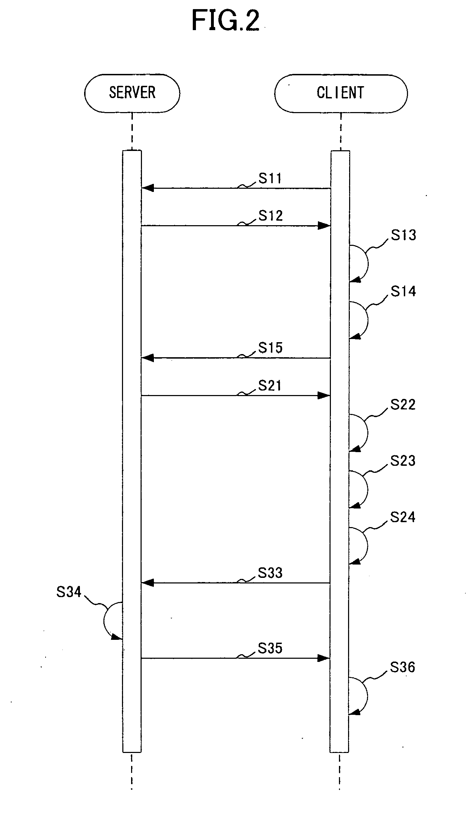

FIG. 2 is a sequence diagram showing an example of operation of the digital transmission circuit design support system according to the present invention. Firstly the browser 23 of the client 2 accesses the server 1 according to a user's instruction (S11). Then, the communication section 11 of the server 1 transmits the standard design-flow file stored in the storage section 12 to the client 2 (S12). When the communication section 21 of the client 2 receives the standard design-flow file, the browser 23 displays the standard design-flow file (S13).

When the examination tool file is selected by the user on the standard design-flow file (S14), the browser 23 transmits the user's request (selection) to the server 1 (S15). In response to the request, the communication section 11 of the server 1 transmits the examination tool file stored in the storage section 12 to the client 2 (S21).

When the communication section 21 of the client 2 receives the examination tool file, the browser 23 starts the examination tool execution section 24 to allow it to execute the examination tool file (S22). The examination tool execution section 24 displays display information and acquires input information according to the content of the examination tool file (S23), and processes the input information so as to display a processing result (S24).

Then, the examination tool execution section 24 allows the communication section 21 to transmit the input information to the server 1 (S33).

When the communication section 11 of the server 1 receives the input information, the input information processing section 13 performs processing for the input information (S34), and the communication section 11 transmits a processing result to the client 2 (S35). When the communication section 21 of the client 2 receives the processing result, the browser 23 displays the processing result (S36), and the sequence is ended.

Next, a concrete example of the examination tool file will be described.

As examples of the examination tool file, a design condition determination tool file, a designer's skill determination tool file, schedule estimation tool file, and a printed circuit board model creation tool file will be described.

Firstly, the design condition determination tool file will be described.

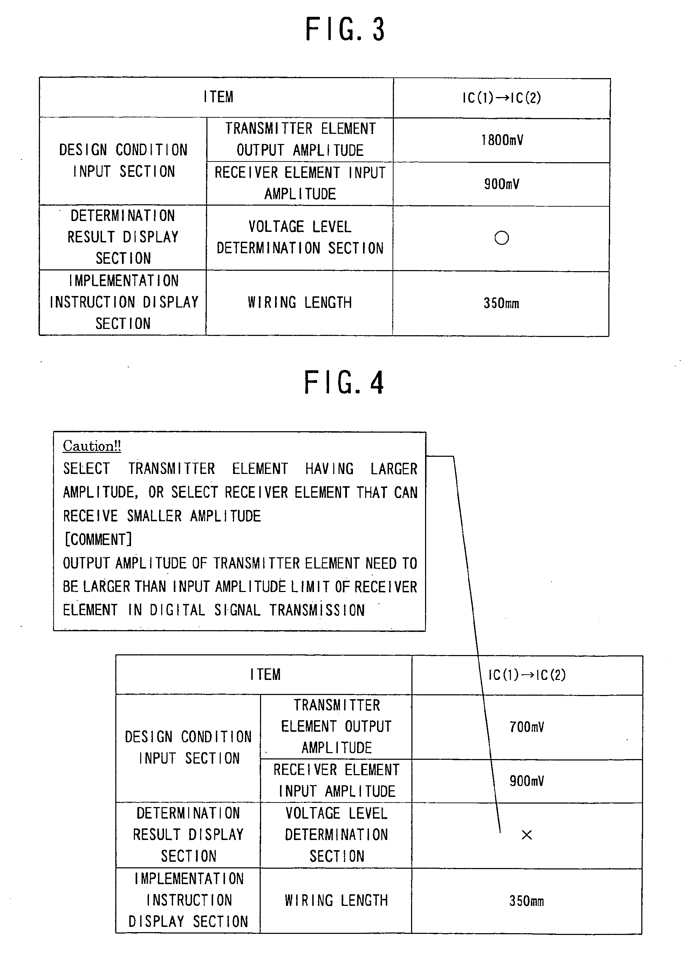

FIG. 3 is a view showing an example of an execution result of the design condition determination tool file according to the present invention. The design condition determination tool file has a design rule determination section, an implementation instruction calculation section, and a setting of a table for input and display of information. The examination tool execution section 24 executes the design rule determination section and implementation instruction calculation section according to the content of the design condition determination tool file to process input information as well as displays a table set in the design condition determination tool file. This table has a setting condition input section, a determination result display section, and an implementation instruction display section. The setting condition input section has an entry field that accepts input information such as transmitter element output amplitude and receiver element input amplitude. The example of FIG. 3 shows a wiring extending from a transmitter element IC (1) to receiver element IC (2).

The design rule determination section previously has a determination expression and determines input information input to the design condition input section based on the determination expression. The determination expression is, for example, represented as follows.

· (transmitter element output amplitude > receiver element input amplitude) is satisfied, OK ("○") is displayed as a determination result.

· Otherwise, NG ("×") is displayed as a determination result.

The implementation instruction calculation section previously has a calculation expression for calculating a wiring length and performs calculation using the input information input to the design condition input section. The calculation expression is, for example, represented as follows.

$$\text{Wiring length} = (\text{transmitter element output amplitude} - \text{receiver element input amplitude}) \times \text{wiring length coefficient}$$

A value depending on the wiring loss is set as the wiring length coefficient.

Next, operation of the examination tool execution section 24 that executes the design condition determination tool file will be described. When the user performs input operation to the design condition input section, the examination tool execution section 24 displays a determination result from the design rule determination section on the determination result display section and a calculation result from the implementation instruction calculation section on the implementation instruction display section.

In the case where the determination result of the design rule determination section is NG (No Good) in the design condition determination tool file, an adequate instruction may be displayed. In this case, the design condition determination tool file can serve also as an educational tool file for training designers. FIG. 4 is a view showing an example of an execution result of the educational tool file according to the present invention. In the example of FIG. 4, a caution message is displayed together with brief comment.

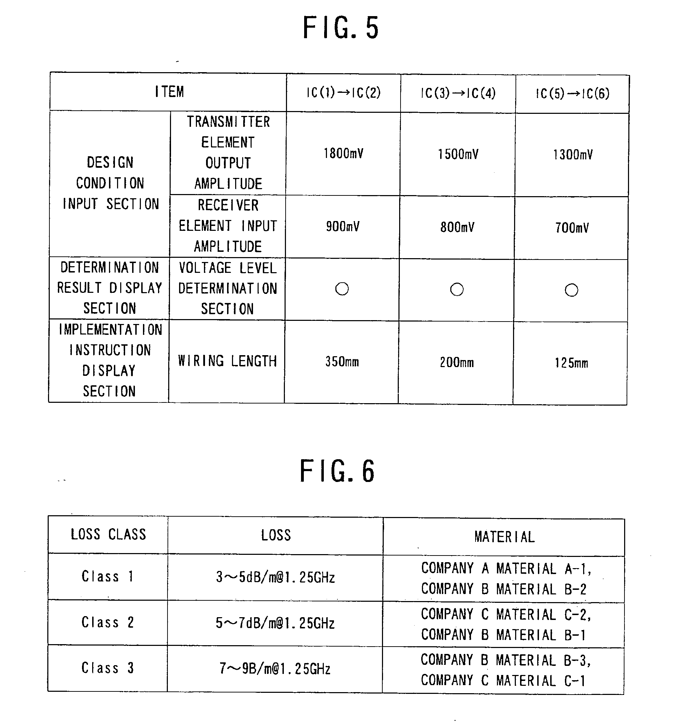

Further, in the table set by the design condition determination tool file, the design condition input section, determination result display section, and implementation instruction display section may be prepared for each interface group constituted by a combination of the transmitter element and receiver element. This allows the single table to deal with a plurality of interface groups. FIG. 5 is a view showing an example of the execution result of the design condition determination tool file according to the present invention in the case where the table set by the design condition determination tool file deals with a plurality of interface groups. In the example of FIG. 5, the design condition input section, determination result display section, and implementation instruction display section are prepared for respective three interface groups of [transmitter element IC (1) → receiver element IC (2)], [transmitter element IC (3) → receiver element IC (4)], and [transmitter element IC (5) → receiver element IC (6)].

The implementation instruction supplied from the implementation instruction calculation section to the implementation instruction display section may be a range of values. In this case, accordingly, the implementation instruction display section displays a range of values.

Another configuration may be employed, in which the server 1 has functions of the design rule determination section and implementation instruction calculation section; the examination tool execution section 24 transmits input information according to the content of the design condition determination tool file to the server 1; the server 1 executes the design rule determination section and implementation instruction calculation section and transmits execution results to the client 2; and the client 2 allows the determination result display section and implementation instruction display section to display the received execution results.

According to the examination tool file, the user can easily check design conditions including the transmitter element output amplitude, receiver element input amplitude, and the like as well as acquire an implementation instruction related, for example, to the wiring length.

The designer's skill determination tool file will next be described.

The designer's skill determination tool file has a designer's skill determination section, a recommended design method selection section, and a setting of a table for input and display of information. The examination tool execution section 24 executes the designer's skill determination section and recommended design method selection section according to the content of the designer's skill determination tool file to process input information and displays a table set in the designer's skill determination tool file. The table has a question display section, an answer input section, a designer's skill display section, and a recommended design method display section.

The question display section displays a question. The question is an item to be checked according to a design rule. For example, "Transmitter element output amplitude is larger than receiver element input amplitude?" is displayed. The answer input section has an entry field that accepts an answer for each question as input information. The designer's skill determination section determines the user's skill level based on the obtained answer using a determination expression. The recommended design method selection section previously has a recommended design method for each designer's skill level that has previously been set and selects a recommended design method corresponding to a result of the determination on the designer's skill.

Next, operation of the examination tool execution section 24 that executes the designer's skill determination tool file will be described. When the examination tool execution section 24 displays a question on the question display section and the user inputs an answer corresponding to the question on the answer input section, the examination tool execution section 24 displays a result of the determination made by the designer's skill determination section on the designer's skill display section and a result of the selection made by the recommended design method selection section on the recommended design method display section.

Another configuration may be employed, in which the server 1 has functions of the designer's skill determination section and recommended design method selection section; the examination tool execution section 24 transmits an input answer according to the content of the designer's skill determination tool file to the server 1; the server 1 executes designer's skill determination section and recommended design method selection section and transmits execution results to the client 2; and the client 2 allows the designer's skill display section and recommended design method display section to display the received execution results. Further, the server 1 may store data of the designer's skill determined by the designer's skill determination section of the server 1.

According to the examination tool file, the user can easily grasp his or her skill level as well as acquire a recommended design method.

The schedule estimation tool file will next be described.

The schedule estimation tool file has a recorded schedule library, a standard schedule estimation section, and a table for display of information. The examination tool execution section 24 executes the recorded schedule library, standard schedule estimation section to process input information and displays the table set in the schedule estimation tool file. The table has a standard schedule display section.

The recorded schedule library stores past schedule records as a library together with the skill information of a designer in charge. The standard schedule estimation section compares the determination result of the designer's skill obtained by the designer's skill determination tool file with the designer's skill stored in the recorded schedule library and, based on the comparison result, selects an adequate recorded schedule as a standard schedule.

Next, operation of the examination tool execution section 24 that executes the schedule estimation tool file will be described. When the user inputs the determination result of the designer's skill obtained by the designer's skill determination tool file as input information, the examination tool execution section 24 displays the standard schedule obtained by the standard schedule estimation section on the standard schedule display section.

Another configuration may be employed, in which the server 1 has functions of the recorded schedule library and standard schedule estimation section and the examination tool execution section 24 transmits the determination result of the designer's skill obtained by the designer's skill determination tool file to the server 1, or the server 1 stores the determination result of the designer's skill determination tool file; the server 1 then executes the standard schedule estimation section and transmits an execution result to the client 2; and the client 2 displays the received execution result on the standard schedule display section.

The printed circuit board model creation tool file will next be described.

The printed circuit board model creation tool file has a frequency characteristic library, a frequency characteristic selection section, a wiring length conversion section, a transmission path simulation model creation section, and a setting table for input of information. The examination tool execution section 24 executes the frequency characteristic library, frequency characteristic selection section, wiring length conversion section, and transmission path simulation model creation section according to the content of the printed circuit board model creation tool file to process input information and displays the table set in the printed circuit board model creation file tool. The table has a design condition input section.

The design condition input section has an entry field that accepts input information such as loss class of the printed circuit board and wiring length. The loss class defines a range of the transmission loss of the printed circuit board. FIG. 6 is a view showing an example of the classes defined in an embodiment of the present invention. The example of FIG. 6 sets a plurality of ranges for the transmission loss, assigns class numbers to respective set ranges, and lists materials belonging to the respective class.

The frequency characteristic library previously stores a frequency characteristic for every loss class as a library. The frequency characteristic selection section searches for a loss class input through the design condition input section from the frequency characteristic library and selects a frequency characteristic corresponding to the input loss class. The wiring length conversion section performs rate calculations for checking correspondence between the frequency characteristic selected by the frequency characteristic selection section and the wiring length input through the design condition input section to thereby obtain a frequency characteristic corresponding to the input wiring length. The transmission path simulation model creation section creates a transmission path simulation model using the frequency characteristic obtained by the wiring length conversion section.

Next, operation of the examination tool execution section 24 that executes the printed circuit board model creation tool file will be described. When the user performs input operations through the design condition input section, the examination tool execution section 24 executes the frequency characteristic selection section, wiring length conversion section, and transmission path simulation model creation section and outputs a transmission path simulation model obtained by the transmission path simulation model as a file.

Another configuration may be employed, in which the server 1 has functions of the frequency characteristics selection section, the wiring length conversion section, and transmission path simulation model creation section; the examination tool execution section 24 transmits input information to the server 1 according to the design condition determination tool file; and the server 1 executes the frequency characteristic selection section, wiring length conversion section, and transmission path simulation model creation section and transmits the obtained file of the transmission path simulation model to the client 2.

According to the examination tool file, the user can easily acquire the transmission path simulation model based on the loss class and wiring length without performing a detailed setting.

As another example of the examination tool file, there may be used a configuration including the design condition input section and implementation instruction calculation section; allowing the user to input a TrTf specification (rise time, fall time) as input information through the design condition input section; allowing the implementation instruction calculation section to calculate a wiring length or the like suitable for the TrTf specification; and allowing a calculation result to be displayed as an implementation instruction. According to this examination tool file, the user can easily grasp an adequate wiring length or the like based on the TrTf specification.

As another example of the examination tool file, there may be used a configuration including the design condition input section and design rule determination section; allowing the user to input the specifications of a plurality of components in their connection order as input information through the design condition input section; and allowing the design rule determination section to determine whether the input connection order is correct or not using the specifications of the components and determination expression. Like the design condition determination tool file, the specification of the component includes, for example, the transmitter element output amplitude and receiver element input amplitude. Further, like the design condition determination tool file, the determination expression checks whether the magnitude relation between the transmitter element output amplitude and receiver element input amplitude is adequate or not. According to this examination tool file, the user can prevent a design error in the connection of the plurality components.

As another example of the examination tool file, there may be used a configuration in which the abovementioned design rule determination section includes a determination expression for determining the magnitude of the risk against the design rule violation and a result of the determination is displayed. According to this examination tool file, it is possible for the designers to share the same recognition concerning the risk. Further, it is possible to prevent the risk factor from adversely affecting processing to be subsequently performed.

As another example of the examination tool file, there may be used a configuration in which a design verification method is displayed on the examination tool. The design verification method is, for example, a waveform measurement method. According to this examination tool file, it is possible to verify design more correctly.

As another example of the examination tool file, there may be used a configuration that checks transmission systems to check a correspondence between a transmission error and environmental condition, thereby specifying a transmission system having the smallest margin. According to this examination tool file, it is only necessary for the user to verify the design of the specified transmission system, thereby reducing the man-hours needed for the verification.

As another example of the examination tool file, there may be used a configuration in which the server 1 stores the designer's skill level and recommends a designer having an adequate skill level for each responsibility unit among the input components and displays the recommendation information. According to this examination tool file, it is possible to establish a safe development environment support.

As another example of the examination tool file, there may be used a configuration that previously displays a result of a sampling inspection performed according to a design procedure and a check list that the user has to go through and allows the user to input answers to the checklist to thereby check design quality. According to this examination tool file, it is possible to reduce the costs and resources needed for design support.

Alternatively, the implementation instruction obtained by the design condition tool file, transmission path simulation model obtained by the printed circuit board model creation tool file, and the like may be stored in any CAD file format. According to this examination tool file, it is possible to directly use the result of the examination tool file as design data without user's confirmation.

Further, it is possible to provide a program that allows a computer constituting the digital transmission circuit design support apparatus to execute the above steps as a digital transmission circuit design support program. By storing the above program in a computer-readable storage medium, it is possible to allow the computer constituting the digital transmission circuit design support apparatus to execute the program. The computer-readable storage medium mentioned here includes: an internal storage device mounted in a computer, such as ROM or RAM, a portable storage medium such as a CD-ROM, a flexible disk, a DVD disk, a magneto-optical disk, or an IC card; a database that holds computer program; another computer and database thereof; and a transmission medium on a network line.

The storage section 12 in the embodiment corresponds to an acquisition section. The step S13 in the embodiment corresponds to a standard design-flow file display step. The step S22 in the embodiment corresponds to an examination tool file execution step. The step S34 in the embodiment corresponds to an input information processing step.

**Claims**

1. A circuit design support apparatus that supports design of a digital circuit, comprising:

   an acquisition section that acquires a standard design-flow file that represents the design procedure of a digital circuit and an examination tool file to be specified, as a program serving as an element of the design procedure, by the standard design-flow file; and
   a communication section that transmits the standard design-flow file to a client according to a request from the client and transmits the examination tool file to the client according to a request from the client.

2. The circuit design support apparatus according to claim 1, wherein
   the examination tool file is received and executed by the client, acquires information input to the client by a user, performs processing for the acquired input information, and allows the client to display a processing result.

3. The circuit design support apparatus according to claim 1, wherein
   the examination tool file is received and executed by the client, acquires information input to the client by a user, and allows the input information to be transmitted from the client to the circuit design support apparatus.

4. The circuit design support apparatus according to claim 3, further comprising:

   an input information processing section that performs processing for the input information based on the input information received from the client.

5. The circuit design support apparatus according to claim 1, wherein
   the input information is a design condition of the digital circuit, and
   the processing for the input information is a determination of whether the input information is a valid value or not.

6. The circuit design support apparatus according to claim 1, wherein
   the processing for the input information is calculation of an implementation instruction such as a wiring length, which is performed based on the input information.

7. The circuit design support apparatus according to claim 1, wherein
   the input information is an answer corresponding to a previously prepared question, the answer being input to said client by a user, and
   the processing for the input information is determination of a skill level of the user, which is made based on the answer.

8. The circuit design support apparatus according to claim 1, wherein
   the processing for the input information determines a design method suited to the user's skill level or determines a design schedule suited to the user's skill level.

9. The circuit design support apparatus according to claim 1, wherein
the input information is a type of printed circuit boards and wiring length that have been previously classified in terms of a transmission loss, and
the processing for the input information is the determination of a frequency characteristic, which is made based on the type of the printed circuit boards and wiring length and creation of a transmission path simulation model, which is performed based on the frequency characteristic.

10. A circuit design support program to be transmitted from a server to a client and allowing a computer to execute a circuit design support method for supporting design of a digital circuit, the program allowing the computer to execute:

   a standard design-flow file display step that displays a standard design-flow file that represents the design procedure of a digital circuit; and
   an examination tool file execution step that executes an examination tool file to be specified, as a program serving as an element of the design procedure, by the standard design-flow file.

11. The circuit design support program according to claim 10, wherein
the examination tool file acquires information input to the client, performs processing for the acquired input information, and allows the client to display a processing result.

12. The circuit design support program according to claim 10, wherein
the examination tool file acquires information input to the client, and allows the input information to be transmitted from the client to the server.

13. The circuit design support program according to claim 12, further allowing the computer to execute, after the examination tool file execution step in the server:

   an input information processing step that performs processing for the input information based on the input information received from the client.

14. The circuit design support program according to claim 10, wherein
the input information is a design condition of the digital circuit, and
the processing for the input information is a determination of whether the input information is a valid value or not.

15. The circuit design support program according to claim 10, wherein
the processing for the input information is calculation of an implementation instruction such as a wiring length, which is performed based on the input information.

16. The circuit design support program according to claim 10, wherein
the input information is an answer corresponding to a previously prepared question, the answer being input to the client by a user, and
the processing for the input information is determination of a skill level of the user, which is made based on the answer.

17. The circuit design support program according to claim 10, wherein
the processing for the input information determines a design method suited to the determined skill level or determines a design schedule suited to the skill level.

18. The circuit design support program according to any of claims 10 to 17, wherein
the input information is a type of printed circuit boards and wiring length that have been previously classified in terms of a transmission loss, and
the processing for the input information is the determination of a frequency characteristic, which is made based on the type of the printed circuit boards and wiring length and creation of a transmission path simulation model, which is performed based on the frequency characteristic.

19. A circuit design support method that supports design of a digital circuit, comprising:

   a standard design-flow file display step that displays a standard design-flow file that represents the design procedure of a digital circuit; and
   an examination tool file execution step that executes an examination tool file to be specified, as a program serving as an element of the design procedure, by the standard design-flow file.

**20.** The circuit design support method according to claim 19, wherein
the examination tool file is received and executed by the client, acquires information input to the client, performs processing for the acquired input information, and allows the client to display a processing result.

# FIG.1

1

**SERVER**

13

INPUT INFORMATION
PROCESSING SECTION

12

STORAGE
SECTION

11

COMMUNICATION
SECTION

2

**CLIENT**

23

BROWSER

24

EXAMINATION
TOOL EXECUTION
SECTION

21

COMMUNICATION
SECTION

NETWORK    3

# FIG.2

# FIG. 3

| ITEM | | IC(1)→IC(2) |
|---|---|---|
| DESIGN CONDITION INPUT SECTION | TRANSMITTER ELEMENT OUTPUT AMPLITUDE | 1800mV |
| | RECEIVER ELEMENT INPUT AMPLITUDE | 900mV |
| DETERMINATION RESULT DISPLAY SECTION | VOLTAGE LEVEL DETERMINATION SECTION | ◯ |
| IMPLEMENTATION INSTRUCTION DISPLAY SECTION | WIRING LENGTH | 350mm |

# FIG. 4

Caution!!

SELECT TRANSMITTER ELEMENT HAVING LARGER AMPLITUDE, OR SELECT RECEIVER ELEMENT THAT CAN RECEIVE SMALLER AMPLITUDE
[COMMENT]
OUTPUT AMPLITUDE OF TRANSMITTER ELEMENT NEED TO BE LARGER THAN INPUT AMPLITUDE LIMIT OF RECEIVER ELEMENT IN DIGITAL SIGNAL TRANSMISSION

| ITEM | | IC(1)→IC(2) |
|---|---|---|
| DESIGN CONDITION INPUT SECTION | TRANSMITTER ELEMENT OUTPUT AMPLITUDE | 700mV |
| | RECEIVER ELEMENT INPUT AMPLITUDE | 900mV |
| DETERMINATION RESULT DISPLAY SECTION | VOLTAGE LEVEL DETERMINATION SECTION | ✕ |
| IMPLEMENTATION INSTRUCTION DISPLAY SECTION | WIRING LENGTH | 350mm |

# FIG. 5

| ITEM | | IC(1)→IC(2) | IC(3)→IC(4) | IC(5)→IC(6) |
|---|---|---|---|---|
| DESIGN CONDITION INPUT SECTION | TRANSMITTER ELEMENT OUTPUT AMPLITUDE | 1800mV | 1500mV | 1300mV |
| | RECEIVER ELEMENT INPUT AMPLITUDE | 900mV | 800mV | 700mV |
| DETERMINATION RESULT DISPLAY SECTION | VOLTAGE LEVEL DETERMINATION SECTION | ○ | ○ | ○ |
| IMPLEMENTATION INSTRUCTION DISPLAY SECTION | WIRING LENGTH | 350mm | 200mm | 125mm |

# FIG. 6

| LOSS CLASS | LOSS | MATERIAL |
|---|---|---|
| Class 1 | 3〜5dB/m@1.25GHz | COMPANY A MATERIAL A-1, COMPANY B MATERIAL B-2 |
| Class 2 | 5〜7dB/m@1.25GHz | COMPANY C MATERIAL C-2, COMPANY B MATERIAL B-1 |
| Class 3 | 7〜9B/m@1.25GHz | COMPANY B MATERIAL B-3, COMPANY C MATERIAL C-1 |

**European Patent Office**

## EUROPEAN SEARCH REPORT

Application Number

EP 06 25 0343

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 530 065 B1 (MCDONALD DUNCAN R [US] ET AL) 4 March 2003 (2003-03-04) <br> * abstract * <br> * figures 1B,1C,2A * <br> * column 7, line 1 - column 10, line 67 * <br> * claims 1-6 * <br> ----- | 1-20 | INV. <br> G06F17/50 |
| X | HIEBER H: "POWER-DESIGN UEBERS WEB" ELEKTRONIK, WEKA FACHZEITSCHRIFTENVERLAG, POING, DE, <br> vol. 49, no. 10, 16 May 2000 (2000-05-16), pages 46-52, XP000948621 <br> ISSN: 0013-5658 <br> * the whole document * <br> ----- | 1-20 | |
| X | GB 2 325 996 A (LSI LOGIC CORP [US]) 9 December 1998 (1998-12-09) <br> * abstract * <br> * figures 3-5 * <br> * page 2, line 15 - line 25 * <br> * page 6, line 5 - page 8, line 8 * <br> ----- | 1,3-10, 12-19 | |
| A | US 6 598 036 B1 (WANG NANXIN [US] ET AL) 22 July 2003 (2003-07-22) <br> * abstract * <br> ----- | 1-20 | TECHNICAL FIELDS SEARCHED (IPC) <br><br> G06F |

The present search report has been drawn up for all claims

| Place of search | Date of completion of the search | Examiner |
|---|---|---|
| Munich | 22 February 2007 | ALONSO NOGUEIRO, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**EP 1 783 644 A1**

## ANNEX TO THE EUROPEAN SEARCH REPORT
## ON EUROPEAN PATENT APPLICATION NO.

EP 06 25 0343

This annex lists the patent family members relating to the patent documents cited in the above-mentioned European search report.
The members are as contained in the European Patent Office EDP file on
The European Patent Office is in no way liable for these particulars which are merely given for the purpose of information.

22-02-2007

| Patent document cited in search report | | Publication date | Patent family member(s) | | Publication date |
|---|---|---|---|---|---|
| US 6530065 | B1 | 04-03-2003 | NONE | | |
| GB 2325996 | A | 09-12-1998 | US | 6397117 B1 | 28-05-2002 |
| US 6598036 | B1 | 22-07-2003 | NONE | | |

For more details about this annex : see Official Journal of the European Patent Office, No. 12/82